# EUROPEAN PATENT SPECIFICATION

(11) **EP 3 806 606 B1**
(45) Date of publication and mention of the grant of the patent: **09.08.2023**
(21) Application number: 18921015.6
(22) Date of filing: 31.05.2018
(51) Int. Cl.: H05K 13/02, H05K 13/04

(54) **FEEDER AND COMPONENT MOUNTER**
ZUFÜHRVORRICHTUNG UND KOMPONENTENMONTIERER
DISTRIBUTEUR ET DISPOSITIF DE MONTAGE D'ÉLÉMENTS

(43) Date of publication of application: 14.04.2021
(73) Proprietor: Fuji Corporation, Chiryu-shi, Aichi 472-8686 (JP)
(72) Inventor: KAWAI, Hidetoshi, Chiryu-shi, Aichi 472-8686 (JP)
(74) Representative: Grünecker Patent- und Rechtsanwälte PartG mbB
(86) International application number: PCT/JP2018/021048
(87) International publication number: WO 2019/229958

(56) References cited:
- EP-A2- 2 672 800
- JP-A- H1 084 198
- JP-A- 2008 053 381
- JP-A- 2012 134 218
- JP-A- 2013 254 895
- JP-A- 2014 112 579
- JP-A- 2017 092 271
- US-A1- 2010 242 267

## Description

### Technical Field

The present description discloses a feeder and a component mounter.

### Background Art

Conventionally, as this type of feeder, there has been proposed a feeder in which when the feeder is removed from a component supply section for an exchange in association with running out of components or failure, an empty tape hanging down from the front of the feeder is rewound to the rear by rotating a feed motor of the feeder reversely so as to rotate a sprocket in a reverse direction (for example, refer to Patent Literature 1). The feeder puts the empty tape out of a hanging-down state by rewinding the empty tape. As a result, the feeder can prevent the empty tape from protruding into a head movable region of a mounter body. Further examples of feeders and component mounters are disclosed in Patent Literature 2 and 3.

### Patent Literature

Patent Literature 1: JP-A- 2013-254895
Patent Literature 2: EP 2 672 800 A2
Patent Literature 3: US 2010/242267 A1

### Summary of the Invention

### Technical Problem

In the feeder described in Patent Literature 1, however, no consideration is taken into for a case in which an operator removes the feeder from a feeder table before the empty tape is rewound. In the event that the feeder is removed from the feeder table before the empty tape is rewound, the empty tape becomes the hanging-down state, being hung from the feeder, and in the event that the feeder is mounted back on the feeder table with this state, there is a possibility that the empty tape is caught between the feeder table and the feeder. Then, when the feeder feeds out the tape to supply components with the empty tape kept so caught, the empty tape is not discharged but is jammed.

A main object of the present disclosure is to suppress the occurrence of a tape jam by eliminating a catch of a tape between a feeder and a feeder table when the feeder is mounted on a component mounter in a state of the tape hanging from the feeder.

### Solution to Problem

With a view to achieving the main object, the present invention is defined in the independent claims. Preferred embodiments are laid down in the dependent claims.

With the feeder of the present disclosure, when the feeder is removed from and mounted back on the feeder table of the mounter body, the jam suppression control is executed in which the motor is caused to be driven to rewind the tape the predetermined amount and the motor is caused to be driven to feed out the tape to the position before the tape is rewound, respectively. As a result, for example, when the operator mounts the feeder back on the feeder table with the tape hanging down from the feeder, even though the tape so hung down is to be caught between the feeder and the feeder table, the occurrence of a tape jam (jamming) can be suppressed by releasing the tape from such a caught state by rewinding the tape. In addition, the feeder also cues up the tape for supply after the tape is released from the caught state, whereby a subsequent supply of components can be executed properly.

The component mounter of the present disclosure includes the cutting device provided on the mounter body for cutting the tape hanging down from the feeder. Then, with the component mounter, when the error occurs in the mounter body, the cutting device is controlled to cause the tape to be cut, and when the feeder is removed from and mounted back on the feeder table with the error left occurring in the mounter body, the jam suppression control is executed. As a result, since the protrusion of the tape from the feeder can be suppressed to a minimum level, the feeder can eliminate a risk of the tape being caught between the feeder and the feeder table by rewinding the tape only a small amount.

### Brief Description of Drawings

[Fig. 1] Fig. 1 is an external perspective view of component mounting system 10.
[Fig. 2] Fig. 2 is a schematic block diagram of component mounter 20.
[Fig. 3] Fig. 3 is an external perspective view of feeder 30.
[Fig. 4] Fig. 4 is a schematic block diagram of feeder 30 and feeder table 40.
[Fig. 5] Fig. 5 is a block diagram showing an electrical connection relationship of component mounting system 10.
[Fig. 6] Fig. 6 is a flowchart showing an example of a feeder management processing routine.
[Fig. 7] Fig. 7 is a flowchart showing an example of a jam suppression control routine.
[Fig. 8] Fig. 8 is an explanatory diagram showing an eliminating operation performed by tape T to eliminate a risk of tape T being caught.
[Fig. 9] Fig. 9 is an explanatory diagram showing an eliminating operation performed by tape T to eliminate a risk of tape T being caught.
[Fig. 10] Fig. 10 is an explanatory diagram showing an eliminating operation performed by tape T to eliminate a risk of tape T being caught.

### Description of Embodiment

Next, a mode for carrying out the present disclosure will be described by reference to drawings.

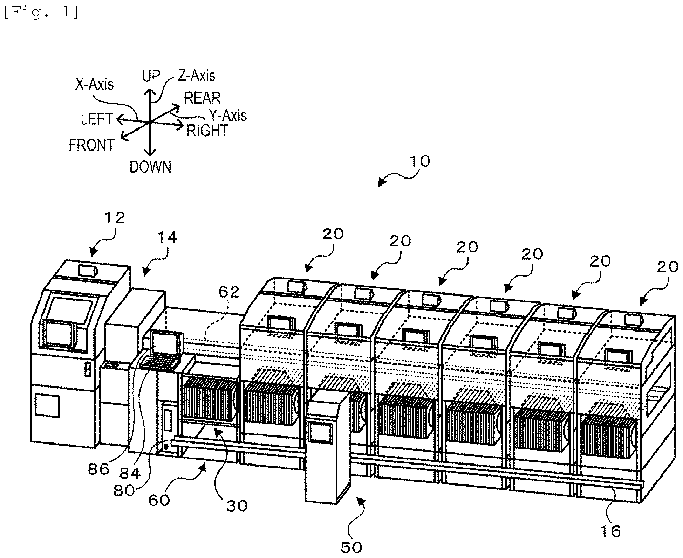

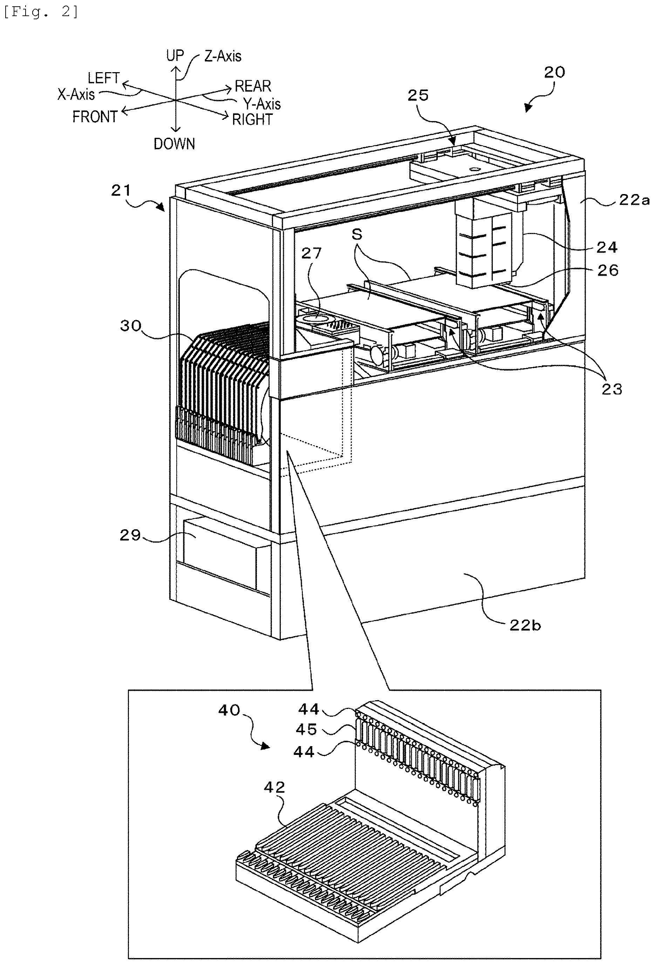

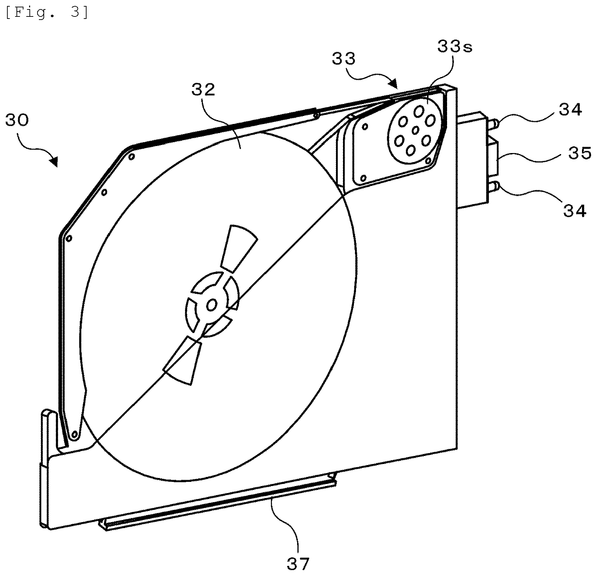

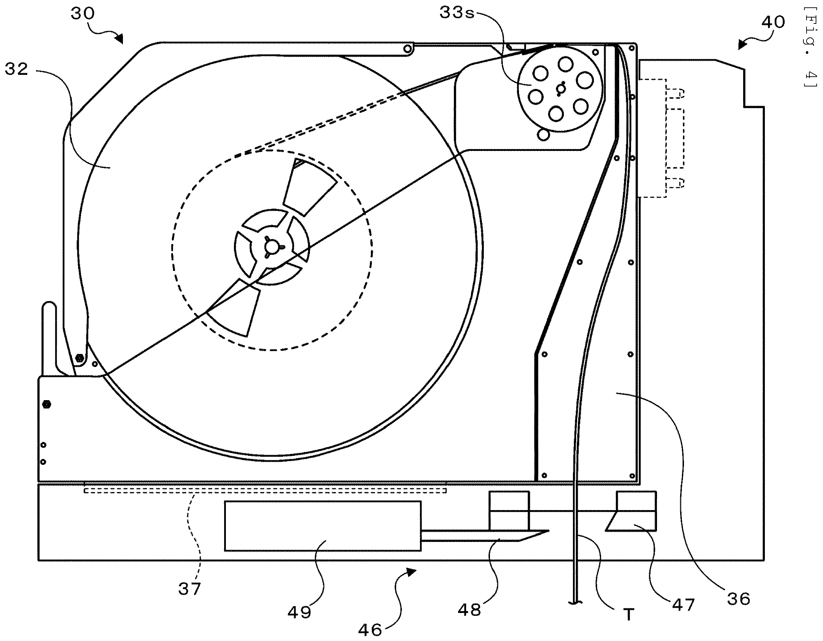

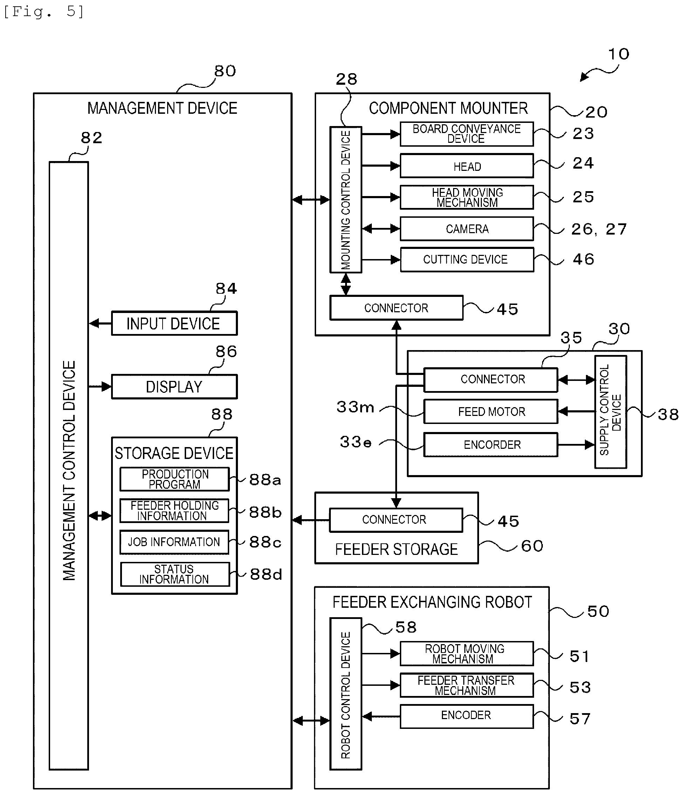

Fig. 1 is an external perspective view of component mounting system 10 of the present embodiment. Fig. 2 is a schematic block diagram of component mounter 20. Fig. 3 is an external perspective view of feeder 30. Fig. 4 is a schematic block diagram of feeder 30 and feeder table 40. Fig. 5 is a block diagram showing an electrical connection relationship of component mounting system 10. In Figs. 1 and 2, a left-right direction is referred to as an X-axis direction, a front-rear direction is referred to as a Y-axis direction, and an up-down direction is referred to as a Z-axis direction.

As shown in Fig. 1, component mounting system 10 includes printing device 12, print inspection device 14, multiple component mounters 20, a mount inspection device (not shown), feeder exchanging robot 50, feeder storage 60, and management device 80 for managing the whole of the system. Printing device 12 is a device for printing solder on board S. Print inspection device 14 is a device for inspecting the state of the solder printed by printing device 12. Component mounters 20 are aligned along a conveyance direction (the X-axis direction) of board S and constitute a device for mounting a component supplied from feeder 30 on board S. The mount inspection device is a device for inspecting the mounting state of the component mounted by component mounter 20. Printing device 12, printing inspection device 14, component mounters 20, and the mount inspection device are set side by side in the conveyance direction of board S in this order and make up a production line. Feeder exchanging robot 50 can move along the production line, and replenishes multiple component mounters 20 with necessary feeders 30 or recovers feeders 30 used up from component mounters 20. Feeder storage 60 is incorporated into the production line and stores feeders 30 to be used and feeders 30 used up in component mounters 20.

As shown in Fig. 2, component mounter 20 includes mounter body 21 and feeders 30 attachable to and detachable from component mounter body 21.

Mounter body 21 includes board conveyance device 23 for conveying board S from left to right, head 24 including a suction nozzle for picking up a component supplied by feeder 30, head moving mechanism 25 for moving head 24 in the front-rear direction and the left-right direction (the X-axis and Y-axis directions), and mounting control device 28 (refer to Fig. 5) for controlling the whole of the system. Board conveyance device 23, head 24, and head moving mechanism 25 are disposed in housing 22a provided on base 22b. In addition to these constituent elements, mounter body 21 includes mark camera 26, part camera 27, and the like. Mark camera 26 is attached to head 24 to image a fiducial mark affixed to board S from above. Part camera 27 is placed between feeder 30 and board conveyance device 23 to image a component picked up and held by the suction nozzle from below when the suction nozzle passes over part camera 27. Mounting control device 28 is made up of known CPU, ROM, RAM, and the like. Image signals from mark camera 26 and part camera 27 are inputted into mounting control device 28. Mounting control device 28 recognizes a position of a board mark, not shown, which is affixed to board S by, for example, processing an image of board S in question captured by mark camera 26. In addition, mounting control device 28 determines whether a component is picked up by and held to the suction nozzle (whether a pickup error is occurring) or determines on a suction position or a suction posture of the component so picked up by the suction nozzle based on an image captured by part camera 27. Further, mounting control device 28 outputs a drive signal to board conveyance device 23, head 24, head moving mechanism 25, or the like.

As shown in Figs. 3, 4, feeder 30 is a rectangular, cassette-type tape feeder and includes tape reel 32, tape feeding mechanism 33, connector 35, empty tape passageway 36, rail member 37, and supply control device 38 (refer to Fig. 5). A tape is wound around tape reel 32. Recessed sections are formed on the tape at predetermined intervals along a longitudinal direction of the tape, and a component is accommodated in each of the recessed sections so formed. These components so accommodated are protected by a film covering a front surface of tape T. Tape feeding mechanism 33 is designed to draw out the tape from tape reel 32 to feed it out to a component supply position and includes sprocket 33s in an outer circumference of which engagement claws are provided in such a manner as to be brought into engagement with engagement holes (not shown) which are provided at equal intervals in the tape and feed motor 33m configured to drive sprocket 33s in both forward and backward rotational directions. In addition, tape feeding mechanism 33 also includes encoder 33e configured to detect a rotational position of sprocket 33s (sprocket position θ). Feeder 30 drives sprocket 33s a predetermined amount of rotation at one time using feed motor 33m so as to feed out the tape in engagement with sprocket 33s a predetermined amount at one time to thereby supply components, being accommodated on the tape, to the component supply position subsequently. The components accommodated on the tape are each put in an exposed state in the component supply position as a result of the film covering them being peeled off immediately before the component supply position, whereby the components so exposed are picked up by the suction nozzle. Connector 35 has two positioning pins 34 which project in an attachment direction. Empty tape passageway 36 is a passageway through which the tape from which the components are removed in the component supply position (hereinafter, also referred to as empty tape T) is discharged downwards by being passed between connector 35 and sprocket 33s. Rail member 37 is provided at a lower end of feeder 30 and extends in the attachment direction. Supply control device 38 is made up of known CPU, ROM, RAM, and the like and outputs a drive signal to tape feeding mechanism 33 (feed motor 33m). In addition, supply control device 38 can communicate with control sections (mounting control device 28, management control device 82, and the like) to which feeder 30 is attached via connector 35.

As shown in Fig. 2, feeder 30 is detachably held onto feeder table 40 provided at a front face of housing 22a of mounter body 21. Multiple feeder tables 40 are aligned in the X-axis direction, and feeders 30 are attached thereto in such a manner as to be aligned side by side in the X-axis direction. Feeder table 40 is an L-shaped table when seen from a side and includes slots 42, pairs of positioning holes 44, and connectors 45. Rail member 37 of feeder 30 is inserted into slot 42. Two positioning pins 34 of feeder 30 are inserted into corresponding pair of positioning holes 44, whereby feeder 30 is positioned on feeder table 40. Connector 45 is provided between pair of positioning holes 44 and is connected with connector 35 of feeder 30.

Further, cutting device 46, which is configured to cut empty tape T hanging down from an exit of empty tape passageway 36, is provided below empty tape passageway 36 of feeder 30 and at a bottom section of feeder table 40. Cutting device 46 includes stationary blade 47, movable blade 48, and driving device 49 configured to drive movable blade 48. Cutting device 46 cuts empty tape T between stationary blade 47 and movable blade 48 by means of a shearing force produced by scissors by moving movable blade 48 towards stationary blade 47 by driving device 49. In the present embodiment, cutting device 46 cuts empty tape T by reciprocating movable blade 48 every time the tape is fed out by tape feeding mechanism 33. Empty tape T so cut is recovered into dust bin 29 disposed in base 22b which supports housing 22a. Alternatively, empty tape T so cut may be conveyed to an outside of mounter body 21 by a conveyor device provided on base 22b along the production line.

Feeder exchanging robot 50 can move along X-axis rail 16 provided parallel to the board conveyance direction (the X-axis direction) on front surfaces of multiple component mounters 20 and a front face of feeder storage 60, as shown in Fig. 1. Feeder exchanging robot 50 includes, as shown in Fig. 5, robot moving mechanism 51, feeder transfer mechanism 53, encoder 57, and robot control device 58. Robot moving mechanism 51 moves feeder exchanging robot 50 along X-axis rail 16. Feeder transfer mechanism 53 transfers feeder 30 between component mounter 20 and feeder storage 60. Encoder 57 detects a movement position of feeder exchanging robot 50 in the left-right direction (the X-axis direction). Robot control device 58 is made up of known CPU, ROM, RAM, and the like and receives a detection signal inputted from encoder 57, while outputting a drive signal to robot moving mechanism 51 and feeder transfer mechanism 53. Feeder exchanging robot 50 moves to a position where it faces component mounter 20 so as to attach and detach feeders 30 to and from feeder table 40 of component mounter 20 in question by controlling robot moving mechanism 51 and feeder transfer mechanism 53.

Feeder storage 60 has multiple feeder tables similar to feeder tables 40 provided in component mounters 20. Feeder exchanging robot 50 moves to a position where it faces feeder storage 60 so as to attach and detach feeders 30 to and from the feeder table of feeder storage 60 by controlling robot moving mechanism 51 and feeder transfer mechanism 53. As a result, feeder exchanging robot 50 can remove feeders 30 to be used, which are stored in feeder storage 60, therefrom and mount them on feeder table 40 of component mounter 20 needing a replenishment or can recovery feeders 30, which are used up in component mounter 20, from feeder table 40 of component mounter 20 in question for feeders 30 so recovered to be accommodated in feeder storage 60.

Management device 80 is a general-purpose computer and includes, as shown in Fig. 5, management control device 82, input device 84 such as a keyboard or a mouse, display 86, and storage device 88. Management control device 82 is made up of CPU, ROM, RAM, and the like, and is electrically connected with input device 84, display 86, and storage device 88. Storage device 88 is HDD or SSD and stores a production program, feeder holding information, job information, status information, and the like. Here, the production program is a program specifying a mounting procedure for each component mounter 20 such as determining: which components are mounted on which board S in which order,or how many board S so mounted are produced. In addition, the feeder information is information relating to feeders 30, which are held by component mounter 20 or feeder storage 60, and includes identification information and mounting position of feeder 30, a residual amount of components in feeder 30, and the like. The job information is information relating to a mounting instruction for each component mounter 20 and includes types of suction nozzles, types and sizes of components to be mounted, mounting positions thereof, and the like. The status information is information indicating an operation status of each component mounter 20, and the operation status includes a status in which a board is being loaded or unloaded, a status in which a component is being mounted (or picked up), a status in which component mounter 20 is at halt due to an occurrence of an error, and the like. Errors occurring in component mounter 20 include the suction error of component P described above.

Management device 80 is wired with mounting control device 28 for communication and exchanges various types of information with each component mounter 20. Management device 80 receives an operation status from each component mounter 20 and updates the status information to a latest one. Additionally, management device 80 is connected with feeder 30 attached to feeder table 40 of each component mounter 20 for communication via supply control device 38 of feeder 30 and mounting control device 28. When feeder 30 is removed from component mounter 20 or new feeder 30 is attached to component mounter 20, management apparatus 80 receives a feeder attachment or detachment status from corresponding component mounter 20 and updates the feeder holding information to a latest one. Further, management device 80 is wirelessly connected with robot control device 58 for communication and exchanges various types of information with feeder exchanging robot 50. In addition to what has been described above, management device 80 is also connected with the various control devices such as printing device 12, print inspection device 14, and the mount inspection device for communication and also exchanges various types of information with the corresponding devices. Management device 80 determines whether a changeover has occurred based on the job information stored in storage device 88 or the mount status received from mounting control device 28 of each component mounter 20, and once control device 80 determines that the changeover has occurred, control device 80 transmits a changeover instruction to robot control device 58. When receiving error information from mounting control device 28, management device 80 outputs information informing of an occurrence of an error to display 86 so as to notify the operator in this respect. Furthermore, when receiving error information, management device 80 transmits to robot control device 58 an instruction to stop an exchange (attachment or detachment) of feeder 30 with (to or from) component mounter 20 until the error is eliminated.

In the case that used-up feeder 30 mounted on feeder table 40 is recovered by feeder exchanging robot 50, mounting control device 28 of component mounter 20 instructs supply control device 38 of used-up feeder 30 to be recovered to perform a rewinding operation of rewinding empty tape T left hanging prior to an execution of a recovery. When receiving the instruction to perform a rewinding operation, supply control device 38 causes cutting device 46 to cut hanging empty tape T and then executes a rewinding operation of causing feed motor 33m to rewind extra empty tape T into feeder 30 by rotating sprocket 33s reversely. A rewind amount of empty tape T is determined to be equal to or longer than a distance from the exit of empty tape passageway 36 to cutting device 46. As a result, empty tape T can be prevented from hanging down from feeder 30, whereby empty tape T can be prevented from being caught between feeder 30 and feeder table 40 next time feeder exchanging robot 50 mounts feeder 30 on feeder table 40 of component mounter 20. In addition, in the case that feeder 30 to be used is mounted on feeder table 40 by feeder exchanging robot 50, component mounter 20 instructs supply control device 38 of feeder 30 to cue up the tape after feeder 30 in question is so mounted. When receiving an instruction to perform a cueing operation, supply control device 38 controls feed motor 33m to feed out the tape to the position before the tape is rewound by rotating sprocket 33s forwards. A tape feed-out amount is determined to be equal to the rewinding amount of empty tape T when the rewinding operation is performed.

In the event that an error is generated in component mounter 20, however, there may occur a case in which the operator temporarily remove feeder 30 to execute an inspection. In this case, feeder 30 is removed from feeder table 40 before the rewinding operation of empty tape T is executed. As a result, the operator does not have to cut empty tape T hanging down from feeder 30 by him or herself. In the event that the operator re-mounts feeder 30 in question on feeder table 40 while forgetting to cut hanging empty tape T, however, there may occur a case in which hanging empty tape T is caught between feeder 30 and feeder table 40. Then, empty tape T continues to be accumulated in an interior of empty tape passageway 36 every time empty tape T is fed out of feeder 30, eventually generating a tape jam (jamming), whereby a proper supply of components cannot be attained.

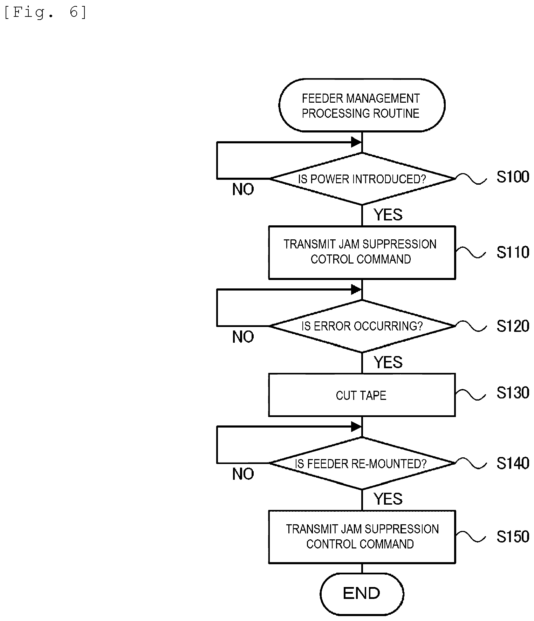

In the following description, an operation (a jam suppression control) of feeder 30 will be described which is performed when power is introduced into component mounter 20 or an error is generated in component mounter 20. Fig. 6 is a flowchart showing an example of a feeder management processing routine executed by mounting control device 28.

When a feeder management processing routine is executed, firstly, mounting control device 28 determines whether power is introduced into component mounter 20 (S100). If it determines that power has been introduced, mounting control device 28 transmits to supply control device 38 a jam suppression control command commanding supply control device 38 to execute a jam suppression control (S110). The jam suppression control will be described later on. Next, mounting control device 28 determines whether an error is generated in component mounter 20 (S120). As described above, the error includes, for example, a suction error of a component. When an error is generated in component mounter 20, mounting control device 28 transmits error information to management device 80. Upon receipt of the error information, management device 80 outputs a warning display to display 86. If it determines that an error is generated in component mounter 20, mounting control device 28 causes cutting devices 46 to cut empty tapes T of all feeders 30 mounted on feeder table 40 of component mounter 20 (S130). Then, mounting control device 28 determines whether all feeders 30 on feeder table 40 have been removed and re-mounted (S140). This determination can be made by examining the feeder holding information. If it determines that all feeders 30 have been removed and remounted, mounting control device 28 transmits a jam suppression control command to supply control device 38 (S150) and ends the present routine.

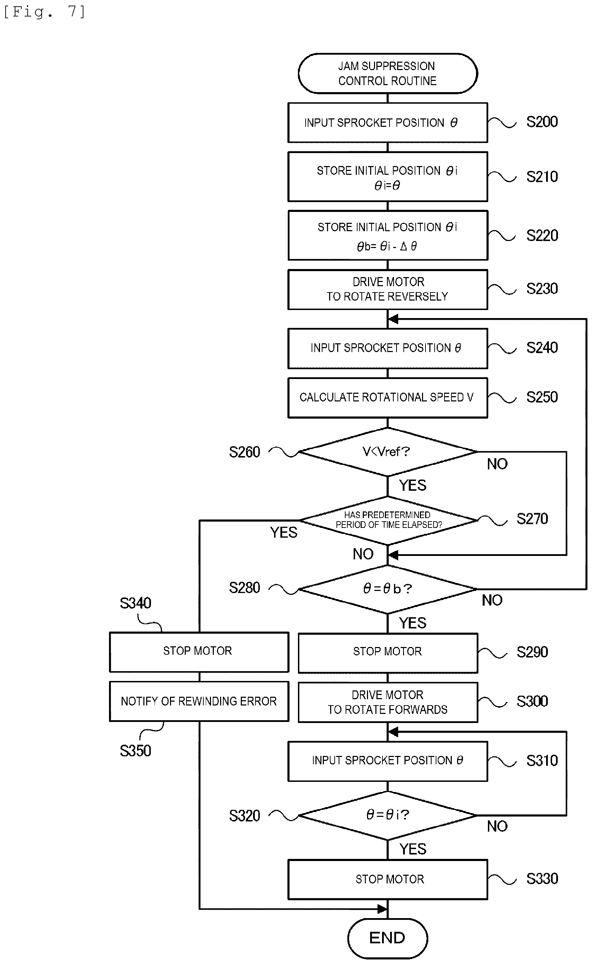

Fig. 7 is a flowchart showing an example of a jam suppression control routine executed by supply control device 38. This routine is executed by supply control device 38 when it receives a jam suppression control command from mounting control device 28.

When the jam suppression control routine is executed, supply control device 38 first inputs sprocket position θ from encoder 33e (S200) and then sets sprocket θ so inputted as initial position θi (S210). Subsequently, supply control device 38 sets a position resulting when sprocket 33s is rotated reversely a predetermined amount Δθ from initial position θi as rewinding position θb (S220). Here, predetermined amount Δθ is a rotational amount necessary to recover a distal end portion of empty tape T which hangs downwards from the exit of empty tape passageway 36 of feeder 30 into an interior of feeder 30 (the interior of empty tape passageway 36) and can be determined, for example, to be slightly longer than a distance from the exit of empty tape passageway 36 to cutting device 46 (stationary blade 47 and movable blade 48). Then, supply control device 38 drives feed motor 33m reversely and starts rotating sprocket 33s reversely (S230).

When starting to rotate sprocket 33s reversely, supply control device 38 inputs the current sprocket position θ from encoder 33e (S240). Subsequently, supply control device 38 calculates rotation speed V of sprocket 33s based on a variation amount per unit time of sprocket position θ so inputted (S250) and determines whether a state in which rotation speed V is smaller than predetermined speed Vref continues for a predetermined period of time (for example, one to two seconds) (S260, S270). Here, predetermined speed Vref constitutes a threshold for use in determining whether sprocket 33s is rotated reversely properly and is determined to be a speed in the vicinity of a value 0. If it determines that rotation speed V of sprocket 33s is not smaller than predetermined speed Vref or determines that even though rotation speed V is smaller than predetermined speed Vref, that state does not continue for the predetermined period of time, supply control device 38 determines whether current sprocket position θ inputted in S240 coincides with rewinding position θb (S280). If it determines that current sprocket position θ does not coincide with rewinding position θb, supply control device 38 returns to S240 to repeat the processings in S240 to S280. If it determines that current sprocket position θ coincides with rewinding position θb, supply control device 38 stops driving feed motor 33m to rotate reversely (S290) and starts driving feed motor 33m to rotate forwards (S300). Then, supply control device 38 inputs current sprocket position θ from encoder 33e (S310) and determines whether current sprocket position θ coincides with initial position θi set in S210 (S320). If it determines that current sprocket position θ does not coincide with initial position θi, supply control device 38 returns to S310 to repeat the processings in S310, S320, whereas if it determines that current sprocket position θ coincides with initial position θi, supply control device 38 stops driving feed motor 33m to rotate forwards (S330) and ends the present routine.

If it determines in S260, S270 that rotation speed V of sprocket 33s is smaller than predetermined speed Vref with such a state continuing for the predetermined period of time, then supply control device 38 determines that empty tape T fails to be rewound properly and then stops feed motor 33m (S340). Then, supply control device 38 informs of an occurrence of a rewinding error (S350) and ends the present routine. The processing in S350 can be executed by providing a display section on feeder 30 or mounter body 21 and causing the display section to display a warning notifying of the occurrence of the rewinding error on the display section. In addition, the process in S350 can also be executed by transmitting a signal notifying of the occurrence of the rewinding error from supply control device 38 to management control device 81 by way of mounting control device 28 and designing management control device 81, which receives the relevant signal, to display a warning notifying of the occurrence of the rewinding error on display 86.

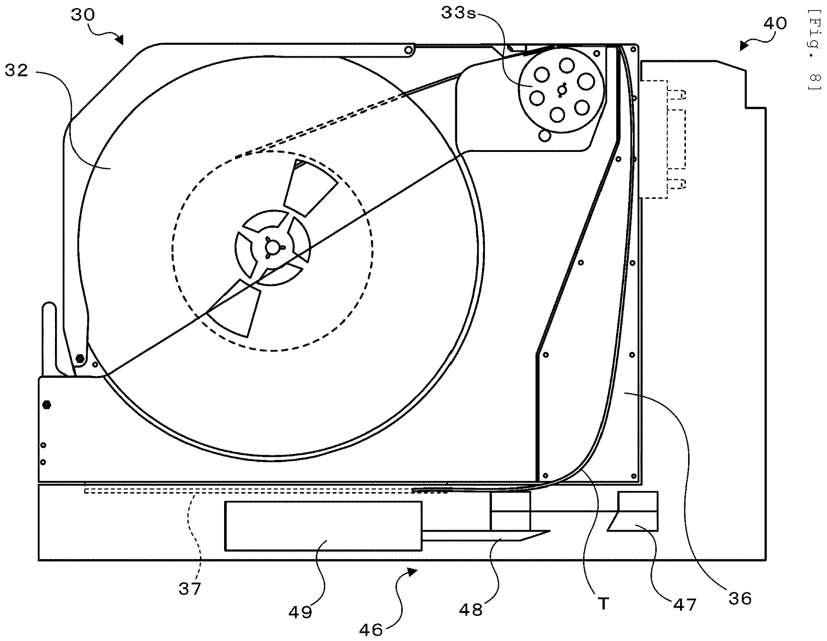

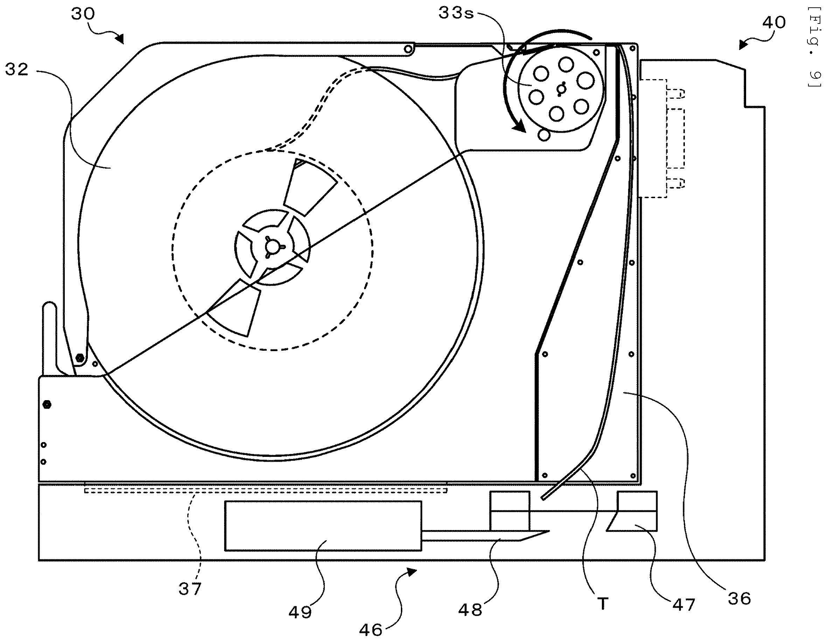

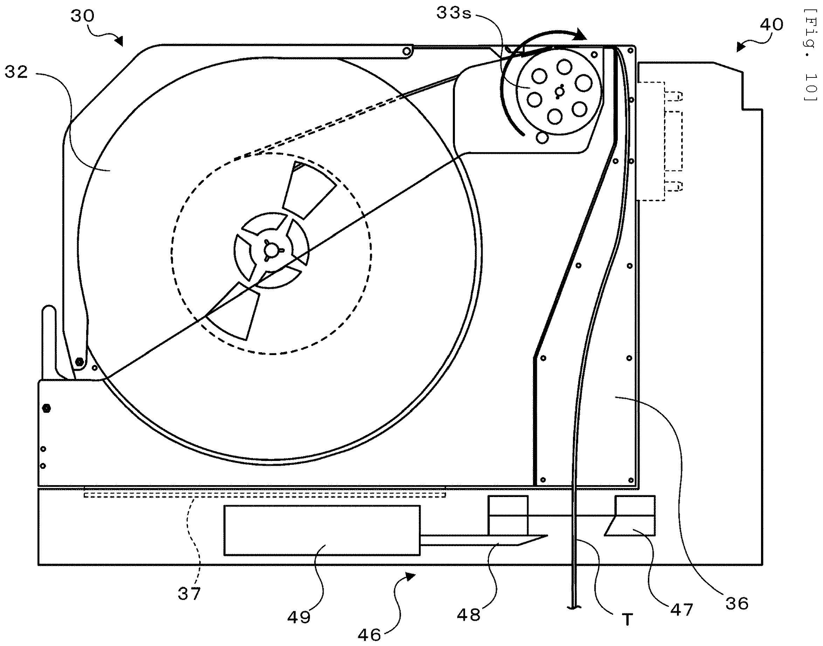

Figs. 8 to 10 are explanatory diagrams showing operations to be performed so as to eliminate catching of empty tape T. As shown therein, there is defined a gap between the exit of empty tape passageway 36 of feeder 30 and cutting device 46 (stationary blade 47 and movable blade 48). As a result, even though empty tape T hanging down from the exit of empty tape passageway 36 is cut by cutting device 46, part of empty tape T protrudes from feeder 30. On the other hand, as described above, when an error occurs in component mounter 20, there may be a case in which the operator removes feeder 30 from feeder table 40 for inspection. In this case, since empty tape T is not cut by cutting device 46, the operator needs to cut an extra portion of empty tape T by him or herself. At this time, in the event that the operator re-mounts feeder 30 on feeder table 40 without cutting empty tape T by an inadvertent error of the operator, there is caused a case in which empty tape T hanging down from feeder 30 is caught between feeder 30 and feeder table 40 as shown in Fig. 8. Then, in the event that feeder 30 continues to feed the tape with empty tape T so caught, empty tape T is accumulated in the interior of empty tape passageway 36, eventually resulting in a situation in which components cannot be supplied properly. With the present embodiment, when an error occurs in component mounter 20, causing feeder 30 to be removed from and then re-mounted on feeder table 40, as shown in Fig. 9, feeder 30 performs the rewinding operation in which sprocket 33s is rotated reversely so as to rewind empty tape T the predetermined amount. As a result, even though empty tape T is left caught between feeder 30 and feeder table 40, empty tape T in question can be drawn out. Subsequently, as shown in Fig. 10, feeder 30 performs the cueing operation in which sprocket 33s is rotated forwards to feed out empty tape T to the position resulting before the rewinding operation is performed. As a result, feeder 30 can perform a subsequent component supply properly as required.

Here, a correspondence between the main constituent elements of the present embodiment and main elements described in claims will be described. That is, feeder 30 corresponds to a "feeder", feed motor 33m corresponds to a "motor", mounter body 21 corresponds to a "mounter body", and feeder table 40 corresponds to a "feeder table".

In the present embodiment that has been described heretofore, when an error occurs in component mounter 20, causing feeder 30 to be remove from and remounted on feeder table 40 by the operator, feeder 30 causes feed motor 33m to be driven to rewind the tape the predetermined amount (executes the rewinding operation). Subsequently, feeder 30 causes feed motor 33m to be driven to feed out the tape to the position before the tape is rewound (executes the cueing operation). By executing these operations, for example, even though empty tape T is caught between feeder 30 and feeder table 40 when the operator re-mounts feeder 30 on feeder table 40 with empty tape T hanging down from feeder 30, such catching of empty tape T can be eliminated by drawing out empty tape T through rewinding empty tape T. As a result, an occurrence of a tape jam (jamming) can be suppressed, which would otherwise be caused as a result of empty tape T being fed out with empty tape T caught between feeder 30 and feeder table 40. In addition, since feeder 30 performs the cueing operation of empty tape T after the catching of empty tape T is eliminated, feeder 30 can perform a subsequent component supply properly as required.

Further, when an error is generated in component mounter 20, component mounter 20 causes cutting device 46 to cut empty tape T hanging down from feeder 30. By doing so, with component mounter 20, a rewinding amount of empty tape T, which is necessary to prevent empty tape T from hanging down from feeder 30, can be reduced by the rewinding operation.

Furthermore, component mounter 20 similarly executes the rewinding operation and the cueing operation of empty tape T also when power is introduced into mounter body 21. As a result, component mounter 20 can deal properly even with such a status in which feeder 30 is detached from and re-attached to feeder table 40 by the operator while the power supply thereto is stopped, and mounter body 21 cannot recognize the detachment and attachment of feeder 30.

When feeder 30 cannot rewind empty tape T properly even by performing the rewinding operation of empty tape T, the feeder 30 suspends the rewinding operation and issues a warning as determining that a rewinding error is occurring, thereby making it possible for the operator to be notified of the error.

Needless to say, the present disclosure is not limited in any way to the embodiment that has been described heretofore and hence can be carried out in various forms within the limits of the appendend claims.

For example, in the embodiment that has been described heretofore, feeder 30 (supply control device 38) determines that a rewinding error is occurring when the state, in which rotation speed V of sprocket 33s is smaller than predetermined speed Vref, continues for the predetermined period of time. However, supply control device 38 need be configured to determine on an occurrence of a rewinding error based on a magnitude of current applied to feed motor 33m.

In the embodiment that has been described heretofore, in the case that it determines that an error is generated in mounter body 21, component mounter 20 executes the cutting operation of cutting empty tape T hanging down from feeder 30 before the rewinding operation of empty tape T in question is executed. However, component mounter 20 need be configured to execute the rewinding operation without executing the cutting operation. In this case, the rewinding amount of empty tape T need be determined properly as required based on an operation interval of cutting device 46 (a tape feeding amount from an execution of a cutting operation by cutting device 46 to a subsequent execution of a cutting operation by cutting device 46).

In the embodiment that has been described above, when power is introduced thereinto, component mounter 20 executes the rewinding operation and the cueing operation of empty tape T irrespective of an occurrence of an error. However, component mounter 20 need be configured not to execute the rewinding operation and the cueing operation of empty tape T when power is introduced thereinto.

### Industrial Applicability

The present disclosure is applicable to a manufacturing industry of feeders and component mounters, and the like.

### Reference Signs List

10 component mounting system, 12 printing device, 14 print inspection device, 16 X-axis rail, 20 component mounter, 21 mounter body, 22a housing, 22b base, 23 board conveyance device, 24 head, 25 head moving mechanism, 26 mark camera, 27 part camera, 28 mounting control device, 30 feeder, 32 tape reel, 33 tape feeding mechanism, 33s sprocket, 33m feed motor, 33e encoder, 34 positioning pin, 35 connector, 36 empty tape passageway, 37 rail member, 39 feeder control device, 40 feeder table, 42 slot, 44 positioning hole,45 connector,50 feeder exchanging robot, 51 robot moving mechanism, 53 feeder transfer mechanism, 57 encoder, 58 robot control device, 60 feeder storage, 80 management device, 82 management control section, 84 input device, 86 display, 88 storage section, S board, T empty tape.

## Claims

1. A feeder (30) configured to be detachably attached to a mounter body (21) for supplying components to the mounter body (21), the feeder (30) comprising:
a motor (33m) configured to feed out a tape (T) accommodating multiple components,
**characterized in that**
when the feeder (30) is removed from a feeder table (40) of the mounter body (21) before the tape (T) is rewound, and re-mounted on the feeder table (40), a jam suppression control is executed in which the motor (33m) is caused to be driven to rewind the tape (T) a predetermined amount and the motor (33m) is caused to be driven to feed out the tape to a position before the tape (T) is rewound, respectively.

2. The feeder (30) according to claim 1,
wherein the motor (33m) feeds out the tape (T) by driving a sprocket (33s) to rotate,
wherein the feeder (30) comprises a rotational position sensor configured to detect a rotational position of the sprocket (33s), and
wherein as the jam suppression control, a rotational position (θ) of the sprocket (33s) detected by the rotational position sensor is stored, the motor (33m) is caused to be driven to rewind the tape (T) a predetermined amount (Δθ), and the motor (33m) is caused to be driven to continue to feed out the tape (T) until a rotational position (θ) of the sprocket (33s) coincides with the rotational position thereof stored.

3. The feeder (30) according to claim 1 or 2,
wherein when a rewinding error of the tape (T) occurs during execution of the jam suppression control, the jam suppression control is suspended, and a predetermined warning is issued for notification of the rewinding error.

4. A feeder (30) configured to be detachably attached to a mounter body (21) for supplying components to the mounter body (21), the feeder (30) comprising:
a motor (33m) configured to feed out a tape (T) accommodating multiple components,
**characterized in that**
when power is introduced into the mounter body (21), after a power supply stop, with the feeder (30) left mounted on a feeder table (40) of the mounter body (21), a jam suppression control is executed in which the motor (33m) is caused to be driven to rewind the tape (T) a predetermined amount and the motor (33m) is caused to be driven to feed out the tape (T) to a position before the tape (T) is rewound.

5. A component mounter (20) comprising:
the feeder (30) according to any one of claims 1 to 4; and
a mounter body (21) configured to mount a component supplied from the feeder (30) on a target object,
wherein the mounter body (21) comprises a cutting device (46) configured to cut a tape (T) hanging down from the feeder (30), and
wherein when an error occurs in the mounter body (21), the cutting device (46) is caused to cut the tape (T), while when the feeder (30) is removed from and re-mounted on the feeder table (40) with the error left occurring, the jam suppression control is executed.

6. The component mounter (20) according to claim 5,
wherein when the feeder (30) is removed from the feeder table (40) to be recovered by a feeder exchanging device (50), the cutting device (46) is caused to be driven to cut a tape (T) hanging down from the feeder (30) before the recovery, and the motor (33m) is caused to be driven to rewind the tape (T) a predetermined amount, and
wherein when the feeder (30) is re-mounted on the feeder table (40) by the feeder exchanging device (50), the motor (33m) is caused to be driven to feed out the tape (T) to a position before the tape (T) is rewound after the feeder (30) is remounted.

## Patentansprüche

1. Zuführvorrichtung (30), die konfiguriert ist, abnehmbar an einem Montagevorrichtungskörper (21) zur Zuführung von Bauteilen zu dem Montagevorrichtungskörper (21) angebracht zu werden, wobei die Zuführvorrichtung (30) umfasst:
einen Motor (33m), der konfiguriert ist, ein Band (T) herauszuführen, das mehrere Bauteile aufnimmt,
**dadurch gekennzeichnet, dass**
wenn die Zuführvorrichtung (30) von einem Zuführvorrichtungstisch (40) des Montagevorrichtungskörpers (21) entfernt wird, bevor das Band (T) zurückgespült ist, und an dem Zuführvorrichtungstisch (40) wieder montiert wird, eine Stauverhinderungssteuerung ausgeführt wird, bei welcher bewirkt wird, dass der Motor (33m) angetrieben wird, um das Band (T) um einen festgelegten Betrag zurückzuspulen bzw. bewirkt wird, dass der Motor (33m) angetrieben wird, um das Band zu einer Position vor Rückspulen des Bands (T) herauszuführen.

2. Die Zuführvorrichtung (30) nach Anspruch 1,
wobei der Motor (33m) das Band (T) durch Antrieb eines Ritzels (33s) zum Drehen herausführt,
wobei die Zuführvorrichtung (30) einen Drehpositionssensor umfasst, der konfiguriert ist, eine Drehposition des Ritzels (33s) zu erfassen, und
wobei als Stauverhinderungssteuerung eine Drehposition (θ) des Ritzels (33s) gespeichert wird, die von dem Drehpositionssensor erfasst ist, bewirkt wird, dass der Motor (33m) angetrieben wird, um das Band (T) um einen festgelegten Betrag (Δθ) zurückzuspulen, und bewirkt wird, dass der Motor (33m) angetrieben wird, um fortzuführen, das Band (T) herauszuführen, bis eine Drehposition (θ) des Ritzels (33s) mit dessen gespeicherter Drehposition übereinstimmt.

3. Die Zuführvorrichtung (30) nach Anspruch 1 oder 2,
wobei, wenn ein Rückspulfehler des Bands (T) während der Ausführung der Stauverhinderungssteuerung auftritt, die Stauverhinderungssteuerung ausgesetzt wird und eine festgelegte Warnung zur Bekanntgabe des Rückspulfehlers ausgegeben wird.

4. Zuführvorrichtung (30), die konfiguriert ist, abnehmbar an einem Montagevorrichtungskörper (21) zur Zufuhr von Bauteilen zu dem Montagevorrichtungskörper (21) angebracht zu werden, wobei die Zuführvorrichtung (30) umfasst:
einen Motor (33m), der konfiguriert ist, ein Band (T) herauszuführen, das mehrere Bauteile aufnimmt,
**dadurch gekennzeichnet, dass**
wenn nach einem Stromzufuhrstopp Strom in den Montagevorrichtungskörper (21) eingeleitet wird, wobei die Zuführvorrichtung (30) an einem Zuführvorrichtungstisch (40) des Montagevorrichtungskörpers (21) montiert verbleibt, eine Stauverhinderungssteuerung ausgeführt wird, bei welcher bewirkt wird, dass der Motor (33m) angetrieben wird, um das Band (T) um einen festgelegten Betrag zurückzuspulen und bewirkt wird, dass der Motor (33m) angetrieben wird, um das Band (T) zu einer Position vor Rückspulen des Bands (T) herauszuführen.

5. Bauteilmontagevorrichtung (20), umfassend:
die Zuführvorrichtung (30) nach einem der Ansprüche 1 bis 4; und
einen Montagevorrichtungskörper (21), der konfiguriert ist, ein von der Zuführvorrichtung (30) zugeführtes Bauteil an einem Zielobjekt zu montieren,
wobei der Montagevorrichtungskörper (21) eine Schneidvorrichtung (46) umfasst, die konfiguriert ist, ein Band (T) zu schneiden, das von der Zuführvorrichtung (30) herabhängt, und
wobei, wenn ein Fehler in dem Montagevorrichtungskörper (21) auftritt, bewirkt wird, dass die Schneidvorrichtung (46) das Band (T) schneidet, wobei, wenn die Zuführvorrichtung (30) von dem Zuführvorrichtungstisch (40) entfernt wird und wieder montiert wird, während der Fehler weiterhin auftritt, die Stauverhinderungssteuerung ausgeführt wird.

6. Die Bauteilmontagevorrichtung (20) nach Anspruch 5,
wobei, wenn die Zuführvorrichtung (30) von dem Zuführvorrichtungstisch (40) entfernt wird, um von einer Zuführvorrichtungs-Austauschvorrichtung (50) zurückgeholt zu werden, bewirkt wird, dass vor einer Rückholung die Schneidvorrichtung (46) angetrieben wird, um ein Band (T) zu schneiden, das von der Zuführvorrichtung (30) herabhängt, und bewirkt wird, dass der Motor (33m) angetrieben wird, um das Band (T) um einen festgelegten Betrag zurückzuspulen, und
wobei, wenn die Zuführvorrichtung (30) an dem Zuführvorrichtungstisch (40) von der Zuführvorrichtungs-Austauschvorrichtung (50) wieder montiert wird, bewirkt wird, dass der Motor (33m) angetrieben wird, um das Band (T) zu einer Position vor dem Rückspulen des Bands (T) herauszuführen, nachdem die Zuführvorrichtung (30) wieder montiert ist.

## Revendications

1. Chargeur (30) configuré pour être fixé de manière amovible à un corps de monteur (21) pour fournir des composants au corps de monteur (21), le chargeur (30) comprenant :
un moteur (33m) configuré pour alimenter une bande (T) contenant plusieurs composants,
**caractérisé en ce que**
lorsque le chargeur (30) est retiré de la table d'alimentation (40) du corps de monteur (21) avant que la bande (T) ne soit rembobinée, et qu'il est remonté sur la table d'alimentation (40), une commande de suppression des bourrages est exécutée dans laquelle le moteur (33m) est entraîné pour rembobiner la bande (T) d'une quantité prédéterminée et le moteur (33m) est entraîné pour dérouler la bande jusqu'à une position avant que la bande (T) ne soit rembobinée, respectivement.

2. Chargeur (30) selon la revendication 1,
le moteur (33m) alimente la bande (T) en entraînant la rotation d'un pignon (33s),
dans lequel le chargeur (30) comprend un capteur de position de rotation configuré pour détecter une position de rotation du pignon (33s), et
dans lequel, en tant que commande de suppression des bourrages, une position de rotation (θ) du pignon (33s) détectée par le capteur de position de rotation est mémorisée, le moteur (33m) est entraîné pour rembobiner la bande (T) d'une quantité prédéterminée (Δθ), et le moteur (33m) est entraîné pour continuer à dérouler la bande (T) jusqu'à ce qu'une position de rotation (θ) du pignon (33s) coïncide avec la position de rotation mémorisée de celui-ci.

3. Chargeur (30) selon la revendication 1 ou 2,
dans lequel lorsqu'une erreur de rembobinage de la bande (T) se produit pendant l'exécution de la commande de suppression des bourrages, la commande de suppression des bourrages est suspendue et un avertissement prédéterminé est émis pour notifier l'erreur de rembobinage.

4. Chargeur (30) configuré pour être fixé de manière amovible à un corps de monteur (21) pour fournir des composants au corps de monteur (21), le chargeur (30) comprenant :
un moteur (33m) configuré pour alimenter une bande (T) contenant plusieurs composants,
**caractérisé en ce que**
lorsque l'alimentation est introduite dans le corps de monteur (21), après un arrêt de l'alimentation, le chargeur (30) restant monté sur une table d'alimentation (40) du corps de monteur (21), une commande de suppression des bourrages est exécutée dans laquelle le moteur (33m) est entraîné pour rembobiner la bande (T) d'une quantité prédéterminée et le moteur (33m) est entraîné pour dérouler la bande (T) jusqu'à une position avant que la bande (T) ne soit rembobinée.

5. Monteur de composants (20) comprenant :
le chargeur (30) selon l'une quelconque des revendications 1 à 4 ; et
un corps de monteur (21) configuré pour monter un composant fourni par le chargeur (30) sur un objet cible,
dans lequel le corps de monteur (21) comprend un dispositif de coupe (46) configuré pour couper une bande (T) suspendue au chargeur (30), et
dans lequel, lorsqu'une erreur se produit dans le corps de monteur (21), le dispositif de coupe (46) est amené à couper la bande (T), tandis que lorsque le chargeur (30) est retiré et remonté sur la table d'alimentation (40) alors que l'erreur ne s'est pas produite, la commande de suppression des bourrages est exécutée.

6. Monteur de composants (20) selon la revendication 5,
dans lequel, lorsque le chargeur (30) est retiré de la table d'alimentation (40) pour être récupéré par un dispositif d'échange de chargeur (50), le dispositif de coupe (46) est entraîné pour couper une bande (T) suspendue au chargeur (30) avant la récupération, et le moteur (33m) est entraîné pour rembobiner la bande (T) d'une quantité prédéterminée, et
dans lequel, lorsque le chargeur (30) est remonté sur la table d'alimentation (40) par le dispositif d'échange de chargeur (50), le moteur (33m) est entraîné pour dérouler la bande (T) jusqu'à une position avant que la bande (T) ne soit rembobinée après le remontage du chargeur (30).
